# EUROPEAN PATENT SPECIFICATION

(11) **EP 2 418 922 B1**
(45) Date of publication and mention of the grant of the patent: **03.04.2013**
(21) Application number: 10305853.3
(22) Date of filing: 02.08.2010
(51) Int. Cl.: H05K 1/02, H04M 7/16, H04M 11/06, H04Q 1/02

(54) **Printed circuit board assembly for POTS-splitters of a VDSL telecommunication system**
Leiterplattenanordnung für POTS-Splitter eines VDSL-Telekommunikationssystems
Assemblage de carte de circuit imprimé pour séparateur POTS d'un système de télécommunication VDSL

(43) Date of publication of application: 15.02.2012
(73) Proprietor: Alcatel Lucent, 75007 Paris (FR)
(72) Inventor: Moesen, Kristof, 1930 Zaventem (BE); Van de Walle, Rudi, 2970 Schilde (BE)
(74) Representative: ALU Antw Patent Attorneys

(56) References cited:
- US-A1- 2002 136 396
- US-A1- 2003 002 656
- US-A1- 2003 112 960

## Description

The present invention relates to a printed circuit board assembly for a Plain Old Telephone System splitter of a VDSL telecommunication system, said assembly comprising a Printed Circuit Board provided with a line interface connector connected to a plurality of low-pass filters on said printed circuit board, said line interface connector being adapted to be coupled to telecommunication lines.

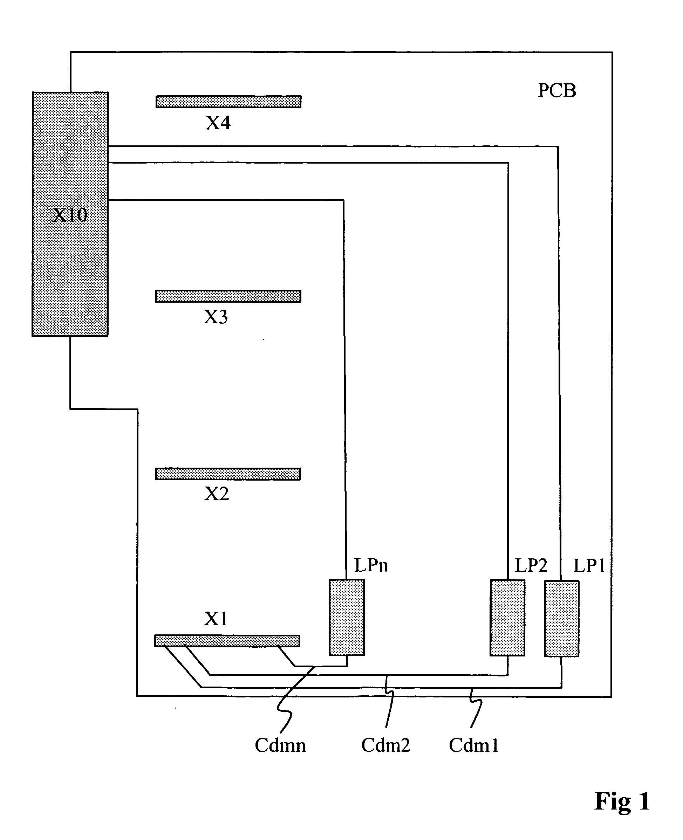

On such a printed circuit board assembly, e.g. as illustrated at Fig. 1, the impact of the low-pass filters LP1, LP2, ... LPn of the Plain Old Telephone System POTS splitter on the VDSL performances of the telecommunication lines needs to be minimized. In other words, the printed circuit board assembly must be designed in such a way that it's line impedance has no effect on the loading of the VDSL signals that are coming from the telecommunication line, and more particularly from the line termination board thereof.

Indeed, this loading effect can result in an attenuation effect of the highest frequencies where it affects the Downstream as well as Upstream VDSL tones. Moreover, it can also have an effect on the matching of the analog front-end towards the line impedance.

A main problem is that the routing from the line interface connector X1 - X4 to the first component of the low-pass filter LP1, LP2, ... LPn has a capacitive effect on the input impedance of the POTS splitter. As a consequence, the capacity of the differential pairs adds up with the input impedance of the low-pass filter.

Another problem is the variation in line interface trace lengths on the Printed Circuit Board PCB, mainly between the line interface connector X1 - X4 and the low-pass filters LP1, LP2, ... LPn. Different lengths of line interface traces on the low-pass filters give spread on the VDSL performance. There is a short line interface trace when the low-pass filter is located near the line interface connector and a long line interface trace when the low-pass filter is located near the board edge of the PCB. A VDSL telecommunication line of which the POTS splitter has a short line interface trace towards the low-pass filter can have a good performance. However, this performance can be reduced for a VDSL telecommunication line with a large splitter line interface traces. This is due to the large Differential Mode Capacitance Cdm1, Cdm2, ... Cdmn of the low-pass filter. Although VDSL performance can be influenced by the analog front-end components, it is very hard to adjust performance for all types of trace lengths towards the different low-pass filters.

The best solution today is to optimize the routing of the differential pair of a VDSL telecommunication line from the line interface connector X1 - X4 towards the low-pass filter LP1, LP2, ... LPn. The components of each low-pass filter are grouped together on the PCB in such a way that the distances between these components, as well as the distance to the line interface connector, are as small as physically possible.

However, bearing in mind that an entire printed circuit board assembly or POTS splitter board is coupled to several lines, e.g. 48 differential pairs of VDSL telecommunication lines, it is obvious that not all low-pass filters LP1, LP2, ... LPn can have the same distance to the line interface connector X1 - X4 and that the line interface trace length towards the line interface connector can be very long if the low-pass filter, e.g. LP1, is situated, in a worst case, at the edge of the printed circuit board PCB. In that case, the capacitive load of the differential pair can be very high and adds up with the low-pass filter input impedance. This will result in a very bad VDSL performance impact.

An object of the present invention is to provide a printed circuit board assembly of the above known type but wherein all the low-pass filters on the printed circuit board PCB provide similar Plain Old Telephone System POTS splitter performance characteristics with respect to the VDSL telecommunication lines.

According to a characterizing embodiment, this object is achieved due to the fact that each low-pass filter of said plurality is physically separated into a front stage comprising at least one component of said low-pass filter connected to said line interface connector and into a rear stage comprising other components of said low-pass filter, and that all the front stages of all the low-pass filters of said plurality are physically located on said printed circuit board closer to said line interface connector than said rear stages.

In this way, the front stages of all the low-pass filters are coupled to the line interface connector via line interface traces having all a similar length. As a result, the performance characteristics of the corresponding Plain Old Telephone System POTS splitters are substantially identical.

It is to be noted that the United States Patent Application US 2002/136396 A1 by Witty, Amy J. et al. and entitled "Insulation strip for a pots splitter card" discloses a splitter card including a circuit board on which line, data and voice connectors are mounted. The connectors include contacts electrically connected to termination posts that extend through the circuit board such that ends of the termination posts are exposed. Therein, a plurality of splitters are connected to the circuit board for splitting composite signals into voice and data signals. The circuit board includes conductive paths for directing composite signals from the line connector to the splitters, for directing voice signals from the splitters to the voice connectors, and for directing data signals from the splitters to the data connectors. Dielectric insulator members are connected to the circuit board to cover the exposed ends of the termination posts.

However, this known document does not disclose nor teach the advantageous characterizing features of the present invention.

Another characterizing embodiment is that said component of said front stage is an inductor coupled to said line interface connector.

Also another characterizing embodiment is that said line interface connector is further adapted to be coupled to a plurality of analog front end high-pass filters also forming part of said Plain Old Telephone System splitters, and that each low-pass filter is associated to a distinct analog front end high-pass filter.

Each Plain Old Telephone System POTS splitter comprises a low-pass filter and an analog front end high-pass filter, also called line transformer. The loading effect of the low-pass filter on the VDSL analog front end is reduced by placing the first inductor, also called line side filter coil, of the low-pass filter as close as possible to the high-pass filter. The physical length of the connection between the line transformer and the line side filter coil is thereby reduced as well as the Differential Mode Capacitance Cdm1 of the POTS splitter.

In a preferred characterizing embodiment, said printed circuit board comprises a plurality of line interface connectors each connected to a distinct plurality of low-pass filters and each adapted to be coupled to telecommunication lines, and all the front stages of all the low-pass filters connected to a predetermined line interface connector are physically located on said printed circuit board closer to said predetermined line interface connector than the rear stages of all these low-pass filters.

In this way, it is for instance possible to place 4 line interface connectors, each connected to 12 front stages of low-pass filters on a same area of the printed circuit board PCB. As a result, 48 Plain Old Telephone System POTS splitter lines are available on a limited PCB board space without influencing the performance, e.g. the bit rate, of the VDSL line termination board.

Further characterizing embodiments of the present printed circuit board assembly are mentioned in the appended claims.

It is to be noticed that the terms "comprising" or "including", used in the claims, should not be interpreted as being restricted to the means listed thereafter. Thus, the scope of an expression such as "a device comprising means A and B" should not be limited to an embodiment of a device consisting only of the means A and B. It means that, with respect to embodiments of the present invention, A and B are essential means of the device.

Similarly, it is to be noticed that the term "coupled", also used in the claims, should not be interpreted as being restricted to direct connections only. Thus, the scope of the expression such as "a device A coupled to a device B" should not be limited to embodiments of a device wherein an output of device A is directly connected to an input of device B. It means that there may exist a path between an output of A and an input of B, which path may include other devices or means.

The above and other objects and features of the invention will become more apparent and the invention itself will be best understood by referring to the following description of an embodiment taken in conjunction with the accompanying drawings wherein:
**Fig. 1** is a schematic view of a printed circuit board assembly comprising POTS splitters of a VDSL telecommunication system; and
**Fig. 2** represents a printed circuit board assembly comprising POTS splitters according to an embodiment of the invention.

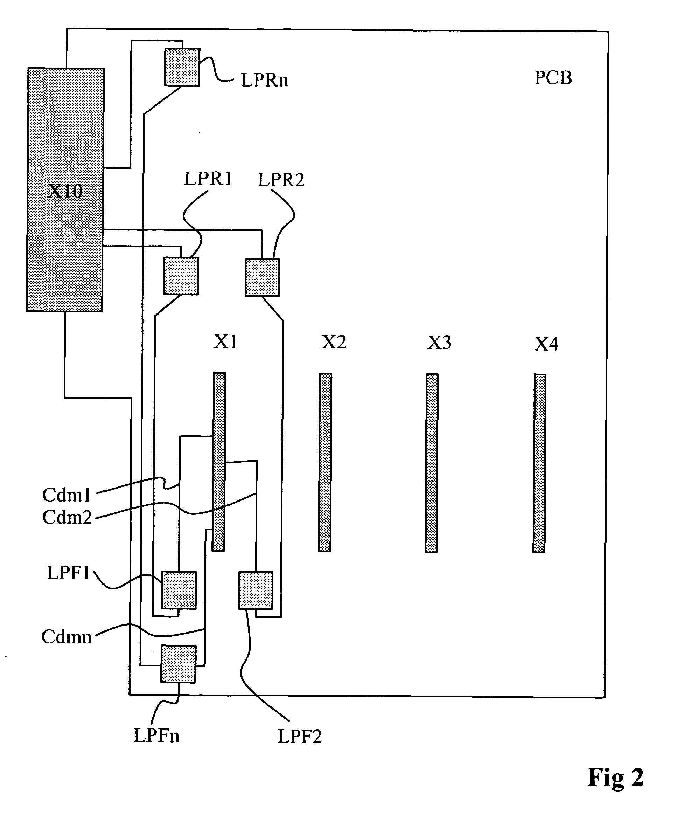

Similarly to the printed circuit board assembly showed at Fig. 1 and described above, the printed circuit board assembly shown at Fig. 2 forms part of Plain Old Telephone System POTS splitter at a Central Office CO of a VDSL telecommunication system.

In such a VDSL telecommunication system, each POTS splitter comprises a low-pass filter LPF1, LPR1; LPF2, LPR2; ... LPFn, LPRn and an analog front end high-pass filter (not shown), also called line transformer.

The printed circuit board assembly comprises a Printed Circuit Board PCB, also called POTS splitter daughterboard, provided with, e.g. 4, groups of 12 low-pass filters, each group of low-pass filters being connected to a distinct line interface connector X1 to X4 also on the PCB.

The 4 line interface connectors X1 - X4 are connected to a line termination VDSL motherboard (not shown) housing the high-pass filters of the splitters. The line termination VDSL motherboard is further connected, together with the 4 line interface connectors X1 - X4, to 48 telecommunication lines towards Customer Premise Equipment CPE.

In order to achieve VDSL requirements, the loading effect of each POTS splitter on the VDSL analog front end must be reduced is such a way that the Differential Mode Capacitance Cdm1, Cdm2, ... Cdmn of the line interface track towards the customer is smaller than 3pF. To this end, the PCB of the printed circuit board assembly has a particular layout, as the embodiment of the invention shown at Fig. 2, wherein all the lines of the Central Office CO POTS splitters are within the 3pF trace length.

In more detail, each low-pass filter LPF1, LPR1; LPF2, LPR2; ... LPFn, LPRn of the POTS splitters on the PCB is physically separated or splitted in a front stage LPF1; LPF2; ... LPFn and a rear stage LPR1; LPR2; ... LPRn.

The front stage LPF1; LPF2; ... LPFn comprises at least one component, preferably the first inductor, also called line side filter coil, of the low-pass filter connected to the line interface connector. This front stage LPF1; LPF2; ... LPFn is physically located on the PCB as close as possible to the line interface connector, here X1 but identical for X2, X3 and X4, and thereby to the high-pass filter of the splitter on the line termination VDSL motherboard.

In this way, the front stage LPF1; LPF2; ... LPFn of the low-pass filter can be placed within the 3pF trace length from the line interface connector, i.e. in the condition where Cdm1; Cdm2; ... Cdmn is smaller than 3pF.

This layout leaves the rest of the PCB open with enough space to mount all the rear or second stages LPR1; LPR2; ... LPRn of low-pass filters. Each rear stage LPR1; LPR2; ... LPRn comprising the remaining components of the low-pass filter that are not comprised in the front stage thereof.

The rear stages LPR1; LPR2; ... LPRn of the low-pass filters are all connected to a POTS interface connector X10 provided of the PCB. This POTS interface connector X10 is further coupled to a POTS interface of a local exchange.

The location of the rear stage LPR1; LPR2; ... LPRn on the PCB is less important as these only carry the base band frequencies, whereby the requirements with respect to the rear stage LPR1; LPR2; ... LPRn are less stringent.

As a result, the front stages LPF1; LPF2; ... LPFn of all the low-pass filters are coupled to the line interface connector X1 - X4 via line interface traces all having substantially the same length. Furthermore, the physical length of the connection between the line transformer and the line side filter coil is thereby also reduced, which positively further affects the Differential Mode Capacitance Cdm1; Cdm2; ... Cdmn.

A final remark is that embodiments of the present invention are described above in terms of functional blocks. From the functional description of these blocks, given above, it will be apparent for a person skilled in the art of designing electronic devices how embodiments of these blocks can be manufactured with well-known electronic components. A detailed architecture of the contents of the functional blocks hence is not given.

While the principles of the invention have been described above in connection with specific apparatus, it is to be clearly understood that this description is merely made by way of example and not as a limitation on the scope of the invention, as defined in the appended claims.

## Claims

1. A printed circuit board assembly for a Plain Old Telephone System splitter of a VDSL telecommunication system, said assembly comprising a printed circuit board provided with a line interface connector (X1 - X4) connected to a plurality of low-pass filters (LPF1, LPR1; LPF2, LPR2; ... LPFn, LPRn) on said printed circuit board, said line interface connector being adapted to be coupled to telecommunication lines,
***characterized in that*** each low-pass filter of said plurality is physically separated into a front stage (LPF1; LPF2; ... LPFn) comprising at least one component of said low-pass filter (LPF1, LPR1; LPF2, LPR2; ... LPFn, LPRn) connected to said line interface connector (X1 - X4) and into a rear stage (LPR1; LPR2; ... LPRn) comprising other components of said low-pass filter,
*and **in that*** all the front stages of all the low-pass filters of said plurality are physically located on said printed circuit board closer to said line interface connector than said rear stages.

2. The printed circuit board assembly according to claim 1, ***characterized in that*** said component of said front stage (LPF1; LPF2; ... LPFn) is an inductor coupled to said line interface connector (X1 - X4).

3. The printed circuit board assembly according to claim 1, ***characterized in that*** said PCB is further provided with a Plain Old Telephone System interface connector (X10) connected to the rear stages (LPR1; LPR2; ... LPRn) of the low-pass filters (LPF1, LPR1; LPF2, LPR2; ... LPFn, LPRn) of said plurality and adapted to be coupled to a Plain Old Telephone System interface of a local exchange.

4. The printed circuit board assembly according to claim 1, ***characterized in that*** said low-pass filter (LPF1, LPR1; LPF2, LPR2; ... LPFn, LPRn) forms part of a Plain Old Telephone System splitter located at a Central Office of said VDSL telecommunication system.

5. The printed circuit board assembly according to claim 1, ***characterized in that*** said line interface connector (X1 - X4) is further adapted to be coupled to a plurality of analog front ends high-pass filters forming part of said Plain Old Telephone System splitters.

6. The printed circuit board assembly according to claim 5, ***characterized in that*** each low-pass filter (LPF1, LPR1; LPF2, LPR2; ... LPFn, LPRn) of said plurality of low-pass filters is associated to a distinct analog front end high-pass filter of said plurality of high-pass filters.

7. The printed circuit board assembly according to claim 1,
***characterized in that*** all the front stages (LPF1; LPF2; ... LPFn) of all the low-pass filters (LPF1, LPR1; LPF2, LPR2; ... LPFn, LPRn) of said plurality surround said line interface connector (X1 - X4) on a first area of said printed circuit board,
*and **in that*** all the rear stages (LPR1; LPR2; ... LPRn) of all the low-pass filters of said plurality are located on a second area of said printed circuit board.

8. The printed circuit board assembly according to claim 1,
***characterized in that*** said printed circuit board comprises a plurality of line interface connectors (X1 - X4) each connected to a distinct plurality of low-pass filters (LPF1, LPR1; LPF2, LPR2; ... LPFn, LPRn) and each adapted to be coupled to telecommunication lines,
*and **in that*** all the front stages (LPF1; LPF2; ... LPFn) of all the low-pass filters of a predetermined plurality of low-pass filters connected to a predetermined line interface connector (X1 - X4) of said plurality of line interface connectors are physically located on said printed circuit board closer to said predetermined line interface connector than the rear stages (LPR1; LPR2; ... LPRn) of all the low-pass filters of said predetermined plurality of low-pass filters.

## Patentansprüche

1. Leiterplattenanordnung für einen POTS-Splitter (Plain Old Telephone System) eines VDSL-Telekommunikationssystems, wobei die besagte Anordnung eine mit einem Leitungsschnittstellenstecker (X1 - X4), welcher an eine Vielzahl von Tiefpassfiltern (LPF1, LPR1; LPF2, LPR2; ... LPFn, LPRn) auf der besagten Leiterplatte angeschlossen ist, versehene Leiterplatte umfasst, wobei der besagte Leitungsschnittstellenstecker dazu ausgelegt ist, an Telekommunikationsleitungen angeschlossen zu werden,
***dadurch gekennzeichnet, dass*** jeder Tiefpassfilter der besagten Vielzahl physisch in eine vordere Stufe (LPF1; LPF2; ... LPFn) mit mindestens einer Komponente des besagten Tiefpassfilters (LPF1, LPR1; LPF2, LPR2; ... LPFn, LPRn), welche an den besagten Leitungsschnittstellenstecker (X1 - X4) angeschlossen ist, und in eine hintere Stufe (LPR1; LPR2; ... LPRn) mit anderen Komponenten des besagten Tiefpassfilters getrennt ist,
*und dass* alle vorderen Stufen aller Tiefpassfilter der besagten Vielzahl physisch näher zu dem besagten Leitungsschnittstellenstecker als die besagten hinteren Stufen auf der besagten Leiterplatte angeordnet sind.

2. Leiterplattenanordnung nach Anspruch 1, ***dadurch gekennzeichnet, dass*** die besagte Komponente der besagten vorderen Stufe (LPF1; LPF2; ... LPFn) ein an den besagten Leitungsschnittstellenstecker (X1 - X4) gekoppelter Induktor ist.

3. Leiterplattenanordnung nach Anspruch 1, ***dadurch gekennzeichnet, dass*** die besagte Leiterplatte weiterhin mit einem POTS-Schnittstellenstecker (X10) ausgestattet ist, welcher an die hinteren Stufen (LPR1; LPR2; ... LPRn) der Tiefpassfilter (LPF1, LPR1; LPF2, LPR2; ... LPFn, LPRn) der besagten Vielzahl angeschlossen und dazu ausgelegt ist, an eine POTS-Schnittstelle einer lokalen Vermittlungsstelle gekoppelt zu werden.

4. Leiterplattenanordnung nach Anspruch 1, ***dadurch gekennzeichnet, dass*** der besagte Tiefpassfilter (LPF1, LPR1; LPF2, LPR2; ... LPFn, LPRn) Teil eines an einer zentralen Vermittlungsstelle des besagten VDSL-Telekommunikationssystems angeordneten POTS-Splitters ist.

5. Leiterplattenanordnung nach Anspruch 1, ***dadurch gekennzeichnet, dass*** der besagte Leitungsschnittstellenstecker (X1 - X4) weiterhin dazu ausgelegt ist, an eine Vielzahl von analogen Front-End-Hochpassfiltern, welche Teil der besagten POTS-Splitter sind, gekoppelt zu werden.

6. Leiterplattenanordnung nach Anspruch 5, ***dadurch gekennzeichnet, dass*** jeder Tiefpassfilter (LPF1, LPR1; LPF2, LPR2; ... LPFn, LPRn) der besagten Vielzahl von Tiefpassfiltern mit einem unterschiedlichen analogen Front-End-Hochpassfilter der besagten Vielzahl von Hochpassfiltern assoziiert ist.

7. Leiterplattenanordnung nach Anspruch 1,
**dadurch gekennzeichnet, dass** alle vorderen Stufen (LPF1; LPF2; ... LPFn) aller Tiefpassfilter (LPF1, LPR1; LPF2, LPR2; ... LPFn, LPRn) der besagten Vielzahl den besagten Leitungsschnittstellenstecker (X1 - X4) in einem ersten Bereich der besagten Leiterplatte umgeben,
und dass alle hinteren Stufen (LPR1; LPR2; ... LPRn) aller Tiefpassfilter der besagten Vielzahl in einem zweiten Bereich der besagten Leiterplatte angeordnet sind.

8. Leiterplattenanordnung nach Anspruch 1,
**dadurch gekennzeichnet, dass** die besagte Leiterplatte eine Vielzahl von Leitungsschnittstellensteckern (X1 - X4) umfasst, welche jeweils an eine unterschiedliche Vielzahl von Tiefpassfiltern (LPF1, LPR1; LPF2, LPR2; ... LPFn, LPRn) angeschlossen sind und jeweils dazu ausgelegt sind, an Telekommunikationsleitungen gekoppelt zu werden,
und dass alle vorderen Stufen (LPF1; LPF2; ... LPFn) aller Tiefpassfilter einer vorbestimmten Vielzahl von Tiefpassfiltern, welche an einen vorbestimmten Leitungsschnittstellenstecker (X1 - X4) der besagten Vielzahl von Leitungsschnittstellensteckern angeschlossen sind, physisch näher zu dem besagten vorbestimmten Leitungsschnittstellenstecker als die hinteren Stufen (LPR1; LPR2; ... LPRn) aller Tiefpassfilter der besagten vorbestimmten Vielzahl von Tiefpassfiltern auf der besagten Leiterplatte angeordnet sind.

## Revendications

1. Assemblage à circuit imprimé pour un séparateur du service téléphonique classique d'un système de télécommunication VDSL, ledit assemblage comprenant un circuit imprimé muni d'un connecteur d'interface de ligne (X1 - X4) relié à une pluralité de filtres passe-bas (LPF1, LPR1; LPF2, LPR2 ; LPFn, LPRn) sur ledit circuit imprimé, ledit connecteur d'interface de ligne étant adapté pour être connecté aux lignes de télécommunication,
***caractérisé en ce que*** chaque filtre passe-bas de ladite pluralité est divisé physiquement en un étage avant (LPF1 ; LPF2 ; ... LPFn) comprenant au moins un composant dudit filtre passe-bas (LPF1, LPR1 ; LPF2, LPR2 ; ... LPFn, LPRn) connecté audit connecteur d'interface de ligne (X1 - X4) et en un étage arrière (LPR1 ; LPR2 ; ... LPRn) comprenant les autres composants dudit filtre passe-bas,
*et **en ce que*** tous les étages avant de tous les filtres passe-bas de ladite pluralité sont placés physiquement sur ledit circuit imprimé plus près dudit connecteur d'interface de ligne que lesdits étages arrière.

2. Assemblage à circuit imprimé selon la revendication 1, ***caractérisé en ce que*** ledit composant dudit étage avant (LPF1 ; LPF2 ; ... LPFn) est une inductance connectée audit connecteur d'interface de ligne (X1 - X4).

3. Assemblage à circuit imprimé selon la revendication 1, ***caractérisé en ce que*** ledit circuit imprimé est en outre muni d'un connecteur d'interface du service téléphonique classique (X10) relié aux étages arrière (LPR1 ; LPR2 ; ... LPRn) des filtres passe-bas (LPF1, LPR1 ; LPF2, LPR2 ; ... LPFn, LPRn) de ladite pluralité et adapté pour être connecté à une interface du service téléphonique classique d'un autocommutateur local.

4. Assemblage à circuit imprimé selon la revendication 1, ***caractérisé en ce que*** ledit filtre passe-bas (LPF1, LPR1 ; LPF2, LPR2; ... LPFn, LPRn) fait partie d'un séparateur du service téléphonique classique qui se trouve au niveau du commutateur central dudit système de télécommunication VDSL.

5. Assemblage à circuit imprimé selon la revendication 1, ***caractérisé en ce que*** ledit connecteur d'interface de ligne (X1 - X4) est en outre adapté pour être relié à une pluralité de filtres passe-haut d'équipements frontaux analogiques faisant partie desdits séparateurs du service téléphonique classique.

6. Assemblage à circuit imprimé selon la revendication 5, ***caractérisé en ce que*** chaque filtre passe-bas (LPF1, LPR1 ; LPF2, LPR2 ; ... LPFn, LPRn) de ladite pluralité de filtres passe-bas est associé à un filtre passe-haut d'équipement frontal analogique distinct de ladite pluralité de filtres passe-haut.

7. Assemblage à circuit imprimé selon la revendication 1,
***caractérisé en ce que*** tous les étages avant (LPF1 ; LPF2 ; ... LPFn) de tous les filtres passe-bas (LPF1, LPR1 ; LPF2, LPR2 ; ... LPFn, LPRn) de ladite pluralité entourent ledit connecteur d'interface de ligne (X1 - X4) sur une première zone dudit circuit imprimé,
*et **en ce que*** tous les étages arrière (LPR1 ; LPR2 ; ... LPRn) de tous les filtres passe-bas de ladite pluralité se trouvent sur une deuxième zone dudit circuit imprimé.

8. Assemblage à circuit imprimé selon la revendication 1,
***caractérisé en ce que*** ledit circuit imprimé comprend une pluralité de connecteurs d'interface de ligne (X1 - X4), chacun relié à une pluralité distincte de filtres passe-bas (LPF1, LPR1 ; LPF2, LPR2 ; ... LPFn, LPRn) et chacun adapté pour être connecté à des lignes de télécommunication,
*et **en ce que*** tous les étages avant (LPF1 ; LPF2 ; ... LPFn) de tous les filtres passe-bas d'une pluralité prédéterminée de filtres passe-bas reliés à un connecteur d'interface de ligne (X1 - X4) prédéterminé de ladite pluralité de connecteurs d'interface de ligne sont placé physiquement sur ledit circuit imprimé plus près dudit connecteur d'interface de ligne prédéterminé que les étages arrière (LPR1 ; LPR2 ; ... LPRn) de tous les filtres passe-bas de ladite pluralité prédéterminée de filtres passe-bas.
